# EUROPEAN PATENT APPLICATION

(11) **EP 4 641 869 A1**
(43) Date of publication of application: **29.10.2025**
(21) Application number: 24766356.0
(22) Date of filing: 01.03.2024
(51) Int. Cl.: H02J 3/36, H02J 13/00

(54) **HIGH-VOLTAGE DIRECT-MOUNTED FLEXIBLE ALTERNATING CURRENT LOOP CLOSING DEVICE**

(30) Priority: 09.03.2023 CN 202310227884
(71) Applicant: NR Electric Co., Ltd, Nanjing, Jiangsu 211102 (CN); NR Engineering Co., Ltd., Nanjing, Jiangsu 211102 (CN); NR Electric Power Electronics Co., Ltd., Changzhou, Jiangsu 213000 (CN)
(72) Inventor: XIE, Yeyuan, Nanjing, Jiangsu 211102 (CN); WANG, Yu, Nanjing, Jiangsu 211102 (CN); LIU, Huancheng, Nanjing, Jiangsu 211102 (CN); DUAN, Jun, Nanjing, Jiangsu 211102 (CN); YANG, Chen, Nanjing, Jiangsu 211102 (CN)
(74) Representative: Kurig, Thomas
(86) International application number: PCT/CN2024/079605
(87) International publication number: WO 2024/183640

(57) **Abstract**

The application provides a high-voltage direct-mounted flexible AC closed-loop device. The high-voltage direct-mounted flexible AC closed-loop device comprises a three-phase converter chain and three multi-winding transformers, wherein the three-phase converter chain connects a first AC system and a second AC system, each phase of the converter chain comprises N active submodules connected in series and a series reactor, and N is an integer greater than or equal to 1; each of the multi-winding transformers comprises a primary winding and N first secondary windings, with the N first secondary windings being connected to the N active submodules in a one-to-one correspondence mode; and the primary winding of each multi-winding transformer is connected to the first AC system or the second AC system.

## Description

### Technical Field

The application relates to the technical field of HVDC, in particular to a high-voltage direct-mounted flexible AC closed-loop device.

### Background

As users' demands for power quality, electricity consumption, and power supply reliability continue to rise, the use of power systems for closed-loop power supply operation has become increasingly widespread.

The closed-loop operation mode of power systems is based on a dual-source power supply approach, which involves a network formed by connecting lines, transformers, or circuit breakers in a closed loop. The benefits of closed-loop operation in the power grid include mutual assistance and support between grids, allowing for load adjustment and backup. This not only enhances the reliability of the power grid or supply but also ensures the electricity supply for critical loads.

However, the conditions for closed-loop operation are quite stringent, requiring that the voltage magnitudes and phases of two power sources be nearly identical to prevent overload of components within the looped network. In practical systems, however, due to the distribution of system impedance or the transformer wiring configurations, there are actual differences in magnitude and phase angle between the two power sources. Direct interconnection of the two power sources may cause excessive currents.

The prior art has proposed solutions for flexible interconnection using power electronic converters. For example, an AC-DC-AC converter is used to connect the AC buses of two power sources, with two back-to-back converters separated by DC isolation. The AC side can regulate the AC voltage magnitude and phase separately, allowing for flexible interconnection. However, this requires two back-to-back full-power converters for rectification and inversion, which presents significant cost and space challenges, especially in high-voltage, large-capacity applications. For instance, using the back-to-back MMC-based VSC-HVDC topology, both rectification and inversion require a three-phase six-bridge arm structure Each bridge arm requiring numerous submodules composed of power semiconductor devices, leading to high costs and significant space requirements, rendering the solution economically inefficient.. In the prior art, series-type solutions may also be adopted, such as the Distributed Power Flow Controller (DPFC). Although this solution achieves improvements in cost and space occupancy, when applied to high-voltage and high-capacity scenarios, its regulation capability is constrained by system impedance. Furthermore, the series-connected configuration places the equipment at a floating high potential, making it difficult to access energy for auxiliary equipment like cooling systems, thereby failing to meet the requirements for grid interconnection and loop operation.. Therefore, there is an urgent need for a high-cost-performance solution that enables the closed-loop operation of power systems.

The above information disclosed in the background art section is only used to enhance the understanding of the background of the invention, so it may contain information that does not constitute the prior art known to those of ordinary skill in the art.

### Summary

To address the above issue, the application provides a high-voltage direct-mounted flexible AC closed-loop device.

In a first aspect, the application provides a high-voltage direct-mounted flexible AC closed-loop device comprising a three-phase converter chain and three multi-winding transformers, wherein
the three-phase converter chain connects a first AC system and a second AC system, each phase of the converter chain comprises N active submodules connected in series and a series reactor, and N is an integer greater than or equal to 1;
each of the multi-winding transformers comprises a primary winding and N first secondary windings, with the N first secondary windings being connected to the N active submodules in a one-to-one correspondence mode; and
the primary winding of each multi-winding transformer is connected to the first AC system or the second AC system.

According to some embodiments, each phase of the converter chain further comprises a reactive submodule or a plurality of reactive submodules connected in series.

According to some embodiments, the multi-winding transformer further comprises K second secondary windings, K is an integer greater than or equal to 1, and the K second secondary windings are led out to serve as AC ports of the high-voltage direct-mounted flexible AC closed-loop device.

According to some embodiments, any one of the N active submodules comprises a first bridge circuit, a first DC capacitor, and a first full-bridge circuit, a DC terminal of the first bridge circuit and a DC terminal of the first full-bridge circuit are connected in parallel with the first DC capacitor, and the first bridge circuit comprises a single-phase full-bridge structure or a three-phase half-bridge structure;
any one of the one or more reactive submodules comprises a second full-bridge circuit and a second DC capacitor, and a DC terminal of the second full-bridge circuit is connected in parallel with the second DC capacitor; and
an AC terminal of the first full-bridge circuit is connected in series with an AC terminal of the second full-bridge circuit, and an AC terminal of the first bridge circuit is connected to the corresponding first secondary winding.

According to some embodiments, a bypass switch is configured at the AC terminal of the first full-bridge circuit or the AC terminal of the second full-bridge circuit, wherein the bypass switch closes in an event of a fault in the active submodules or reactive submodules.

According to some embodiments, the high-voltage direct-mounted flexible AC closed-loop device further comprises:
three high-voltage isolation transformers, wherein primary windings of the high-voltage isolation transformers are connected in parallel and then connected to the first AC system or the second AC system, or independently connected to the first AC system or the second AC system, and secondary windings of the high-voltage isolation transformers are connected to the primary windings of the corresponding multi-winding transformers, respectively.

According to some embodiments, a line voltage of the secondary winding of the high-voltage isolation transformer is less than that of the primary winding thereof, and an insulation voltage to ground of the secondary winding of the high-voltage isolation transformer is not less than that of the primary winding thereof.

According to some embodiments, the high-voltage isolation transformer is positioned at ground potential and further comprises a primary insulation bushing and a secondary insulation bushing, and insulation voltages to ground of the primary winding, the secondary winding, the primary insulation bushing, and the secondary insulation bushing of the high-voltage isolation transformer are not less than a voltage to ground of the first AC system or the second AC system.

According to some embodiments, the high-voltage direct-mounted flexible AC closed-loop device further comprises insulators above ground and a high-potential platform,
wherein the insulators above ground are used to support the high-potential platform, and the converter chain and the multi-winding transformers are mounted on the high-potential platform; and
an insulation voltage of the insulator above ground is not less than a voltage to ground of the first AC system or the second AC system.

According to some embodiments, the high-potential platform is a metal platform;
the converter chain is supported on the metal platform by platform insulators or is arranged within a box structure on the metal platform;
the series reactor is supported on the metal platform by platform insulators or supported on the ground by insulators above ground; and
the multi-winding transformers are placed on the metal platform.

According to some embodiments, when the high-voltage direct-mounted flexible AC closed-loop device is arranged outdoors, the three-phase converter chain is placed inside a container, the N first secondary windings of the multi-winding transformer pass through the container and are correspondingly connected to the N active submodules, and the K second secondary windings of the multi-winding transformer pass through the container and are connected to a cooling system.

According to some embodiments, the high-voltage direct-mounted flexible AC closed-loop device further comprises a cooling system, wherein an air cooler of the cooling system is arranged at a top of the converter chain or the container.

According to some embodiments, when the three-phase converter chain and the multi-winding transformers are arranged indoors, and where the high-voltage isolation transformers and the series reactor are placed outdoors, the secondary windings of the high-voltage isolation transformers and the primary windings of the multi-winding transformers are connected via wall bushings; and
an insulation voltage to ground of the wall bushing is not less than a voltage to ground of the first AC system or the second AC system.

According to some embodiments, the high-voltage direct-mounted flexible AC closed-loop device further comprises a cooling system comprising at least one of: a cooling subunit, a water cooling system, and an air conditioning system.

According to some embodiments, the cooling system is arranged at ground potential, and a coolant of the cooling system is lifted to a position of the converter chain through water cooling pipes.

According to some embodiments, the high-voltage direct-mounted flexible AC closed-loop device further comprises a control system communicating with the converter chain via optical fibers.

The application proposes a high-voltage direct-mounted flexible AC closed-loop device which is connected between two AC power sources, which originate from power systems in the same or nearby regions. The phase angle difference and magnitude difference between the two power sources are both relatively minor, and actual equipment withstands lower voltage during operation, exhibiting significant advantages in operational losses, equipment footprint, and equipment costs.

According to the technical scheme of this application, the multi-winding transformers are employed to provide stable energy supply to the submodules. In high-voltage scenarios, the high-voltage isolation transformers are used to reduce the primary voltage of the multi-winding transformer, thereby lowering the design and manufacturing complexity of the multi-winding transformer. This application also proposes using two types of secondary windings for the multi-winding transformer, with one portion connected to the submodules and the other portion connected to other electrical loads of the device, addressing the high potential energy supply issue of the cooling system.

Additionally, this application provides an installation method for the device to be used in high-voltage scenarios, where the converter chain and the multi-winding transformers are arranged by phase and placed on the high-potential platform supported by insulators above ground, achieving the insulation configuration for the high-voltage direct-mounted flexible AC closed-loop device.

It should be understood that the above general description and the following detailed description are only exemplary, and do not limit the application.

### Brief Description of the Drawings

The above and other objects, features and advantages of the application will become more apparent by describing in detail exemplary embodiments with reference to the accompanying drawings. The drawings described below are only some embodiments of the application, and do not limit the application.
Fig. 1 is a diagram of a high-voltage direct-mounted flexible AC closed-loop device according to an exemplary embodiment;
Fig. 2 is a diagram of an active submodule according to an exemplary embodiment;
Fig. 3 is a diagram of a reactive submodule according to an exemplary embodiment;
Fig. 4 is a diagram of the arrangement of a high-voltage direct-mounted flexible AC closed-loop device according to an exemplary embodiment;
Fig. 5 is a diagram of the arrangement of a high-voltage direct-mounted flexible AC closed-loop device according to another exemplary embodiment;
Fig. 6 is a diagram of the arrangement of a high-voltage direct-mounted flexible AC closed-loop device according to yet another exemplary embodiment;
Fig. 7 is a diagram of the arrangement of a three-phase high-voltage direct-mounted flexible AC closed-loop device according to an exemplary embodiment.

### Detailed Description of Embodiments

Exemplary embodiments will be described more fully below with reference to the accompanying drawings. However, the exemplary embodiments can be implemented in various forms and should not be construed as limited to the embodiments set forth herein. These embodiments are provided to make this application more thorough and complete, and to fully convey the concept of the exemplary embodiments to those skilled in the art. In the drawings, the same reference signs refer to the same or similar parts, so repeated descriptions will be omitted.

The described features, structures, or characteristics may be combined in any suitable manner in one or more embodiments. In the following description, numerous specific details are provided to give a thorough understanding of the embodiments of the disclosure. However, those skilled in the art will realize that the technical solution of the disclosure can be practiced without one or more of these specific details, or other ways, components, materials or devices can be adopted. In these cases, well-known structures, methods, devices, implementations, materials or operations will not be shown or described in detail.

The flowchart shown in the drawings is only an exemplary illustration, and does not necessarily include all contents and operations/steps, nor does it have to be executed in the described order. For example, some operations/steps can be decomposed, while others can be merged or partially merged, so the actual execution order may change according to the actual situation.

Terms such as "first" and "second" in the specification and claims of this application and the drawings are used to distinguish different objects, but not to describe a specific order. Further, the terms "comprise" and "have" and any variations thereof are intended to cover non-exclusive inclusion. For example, a process, method, system, product or device comprising a series of steps or units is not limited to the listed steps or units, but optionally comprises steps or units not listed, or optionally comprises other steps or units inherent to the process, method, product or device.

Those skilled in the art can understand that the drawings are only diagrams of the exemplary embodiments. The modules or processes in the drawings are not necessarily a must for the implementation of this application, so they cannot be used to limit the scope of this application.

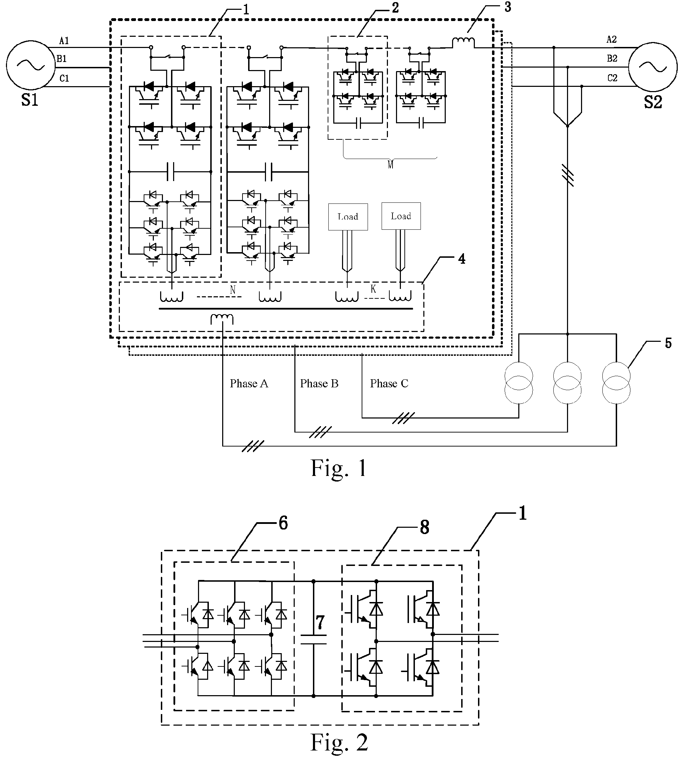

Fig. 1 is a diagram of a high-voltage direct-mounted flexible AC closed-loop device according to an exemplary embodiment.

As shown in Fig. 1, the high-voltage direct-mounted flexible AC closed-loop device comprises a three-phase converter chain and multi-winding transformers 4 connected to a first AC system S1 and a second AC system S2, wherein

Each phase of the converter chain comprises N active submodules 1 connected in series, M reactive submodules 2, and a series reactor 3, N≥1, and M≥0.

According to an exemplary embodiment, as shown in Fig. 2, each active submodule comprises a first bridge circuit 6, a first DC capacitor 7, and a first full-bridge circuit 8, and a DC terminal of the first bridge circuit 6 and a DC terminal of the first full-bridge circuit 8 are connected in parallel with the first DC capacitor 7.

According to some embodiments, the first bridge circuit 6 comprises a single-phase full-bridge structure or a three-phase half-bridge structure. The first bridge circuit in this application is implemented using the three-phase half-bridge structure as an example, but is not confined to it.

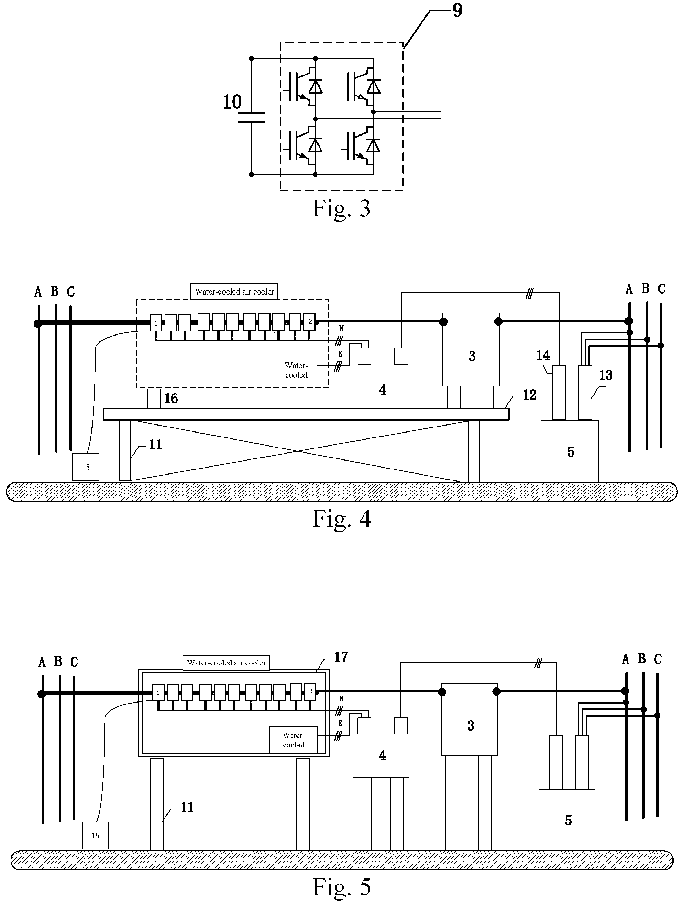

According to an exemplary embodiment, as shown in Fig. 3, each reactive submodule 2 comprises a second full-bridge circuit 9 and a second DC capacitor 10, and a DC terminal of the second full-bridge circuit 9 is connected in parallel with the second DC capacitor 10.

According to an exemplary embodiment, each of the active submodules and reactive submodules comprises a bypass switch, configured at an AC terminal of the first full-bridge circuit 8 or an AC terminal of the second full-bridge circuit 9. The bypass switch closes in an event of a fault in the active submodules or reactive submodules.

Each multi-winding transformer 4 comprises one primary winding and N+K secondary windings, where K ≥ 0. The N secondary windings are connected to the N active submodules 1 in a one-to-one correspondence mode, while the K secondary windings are led out to serve as AC ports of the high-voltage direct-mounted flexible AC closed-loop device. The primary winding of the multi-winding transformer 4 is directly connected to the first AC system S1 or the second AC system S2.

According to an exemplary embodiment, the AC terminal of the first full-bridge circuit 8 is connected in series with the AC terminal of the second full-bridge circuit 9, and an AC terminal of the first bridge circuit 6 is connected to the corresponding secondary winding of the multi-winding transformer 4.

According to an exemplary embodiment, the high-voltage direct-mounted flexible AC closed-loop device further comprises three high-voltage isolation transformers 5, wherein primary windings of the high-voltage isolation transformers 5 are connected in parallel and then connected to the first AC system S1 or the second AC system S2, or independently connected to the first AC system S1 or the second AC system S2, and secondary windings of the high-voltage isolation transformers 5 are connected to the primary windings of the corresponding multi-winding transformers 4, respectively. That is, the primary windings of the multi-winding transformers 4 are connected to the first AC system S1 or the second AC system S2 via the high-voltage isolation transformers 5. Fig. 1 illustrates the connection to the AC system after the primary windings of the high-voltage isolation transformers 5 are connected in parallel, but this application is not limited to this configuration.

According to some embodiments, a line voltage of the secondary winding of the high-voltage isolation transformer 5 is less than that of the primary winding thereof, and an insulation voltage to ground of the secondary winding of the high-voltage isolation transformer 5 is not less than that of the primary winding thereof.

The application proposes a high-voltage direct-mounted flexible AC closed-loop device which is connected between two AC power sources, which originate from power systems in the same or nearby regions. The phase angle difference and magnitude difference between the two power sources are both relatively minor, and actual equipment withstands lower voltage during operation, exhibiting significant advantages in operational losses, equipment footprint, and equipment costs.

According to the technical scheme of this application, the multi-winding transformers are employed to provide stable energy supply to the submodules. In high-voltage scenarios, the high-voltage isolation transformers are used to reduce the primary voltage of the multi-winding transformer, thereby lowering the design and manufacturing complexity of the multi-winding transformer. This application also proposes using two types of secondary windings for the multi-winding transformer, with one portion connected to the submodules and the other portion connected to other electrical loads of the device, addressing the high potential energy supply issue of the cooling system.

Fig. 4 is a diagram of the arrangement of a high-voltage direct-mounted flexible AC closed-loop device according to an exemplary embodiment.

As shown in Fig. 4, the high-voltage direct-mounted flexible AC closed-loop device further comprises insulators above ground 11 and a high-potential platform 12, wherein the converter chain and the multi-winding transformers are arranged by phase and placed on the high-potential platform 12 supported by the insulators above ground 11.

According to an exemplary embodiment, an insulation voltage of the insulator above ground 11 is not less than a voltage to ground of the first AC system S1 or the second AC system S2.

According to some embodiments, the high-potential platform 12 is a metal platform; each converter chain is supported on the metal platform by platform insulators 16 or is arranged within a box structure on the metal platform; the series reactor 3 is supported on the metal platform by platform insulators 16 or supported on the ground by insulators above ground; and the multi-winding transformers 4 are placed on the metal platform. This diagram shows the series reactor 3 being supported on the metal platform by the platform insulators 16 as an example, but this application is not confined to this arrangement.

According to an exemplary embodiment, the high-voltage direct-mounted flexible AC closed-loop device further comprises a cooling system connected to the K secondary windings of the multi-winding transformer 4.

According to an exemplary embodiment, the high-voltage isolation transformer 5 is positioned at ground potential and comprises a primary insulation bushing 13 and a secondary insulation bushing 14.

According to some embodiments, insulation voltages to ground of the primary winding, the secondary winding, the primary insulation bushing 13, and the secondary insulation bushing 14 of the high-voltage isolation transformer 5 are not less than a voltage to ground of the first AC system S1 or the second AC system S2.

According to an exemplary embodiment, the high-voltage direct-mounted flexible AC closed-loop device further comprises a control system 15 communicating with the converter chain via optical fibers.

Additionally, this application provides an installation method for the device to be used in high-voltage scenarios, where the converter chain and the multi-winding transformers are arranged by phase and placed on the high-potential platform supported by the insulators above ground, achieving the insulation configuration for the high-voltage direct-mounted flexible AC closed-loop device.

Fig. 5 is a diagram of the arrangement of a high-voltage direct-mounted flexible AC closed-loop device according to another exemplary embodiment.

As shown in Fig. 5, the high-voltage direct-mounted flexible AC closed-loop device is arranged outdoors and further comprises insulators above ground 11 and a container 17, wherein the container 17, the multi-winding transformers 4, and the series reactor 3 are supported by the insulators above ground 11, the three-phase converter chain is placed inside the container 17, the N secondary windings of the multi-winding transformer 4 pass through the container 17 and are correspondingly connected to the N active submodules 1, and the K secondary windings of the multi-winding transformer 4 also pass through the container 17 and are connected to an AC or DC load, as illustrated by a water cooling system in the diagram.

According to some embodiments, the AC or DC load comprises a cooling system, wherein an air cooler of the cooling system is arranged at a top of the container 17.

According to an exemplary embodiment, the high-voltage isolation transformer 5 is positioned at ground potential and comprises a primary insulation bushing 13 and a secondary insulation bushing 14.

According to some embodiments, insulation voltages to ground of the primary winding, the secondary winding, the primary insulation bushing 13, and the secondary insulation bushing 14 of the high-voltage isolation transformer 5 are not less than a voltage to ground of the first AC system S1 or the second AC system S2.

According to an exemplary embodiment, the high-voltage direct-mounted flexible AC closed-loop device further comprises a control system 15 communicating with the converter chain via optical fibers.

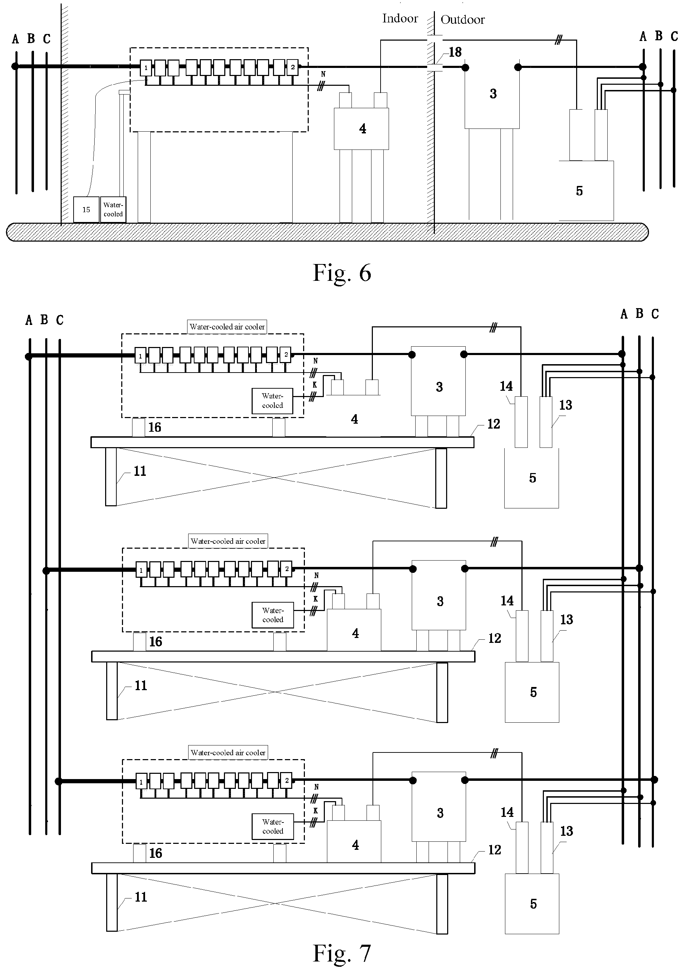

Fig. 6 is a diagram of the arrangement of a high-voltage direct-mounted flexible AC closed-loop device according to yet another exemplary embodiment.

As shown in Fig. 6, the converter chain and the multi-winding transformers are arranged indoors, and where the high-voltage isolation transformers 5 and the series reactor 3 are placed outdoors, the secondary windings of the high-voltage isolation transformers 5 and the primary windings of the multi-winding transformers 4 are connected via wall bushings 18, and the reactive submodules 2 in the converter chain are connected to the series reactor 3 via the wall bushings 18.

According to some embodiments, an insulation voltage to ground of the wall bushing 18 is not less than a voltage to ground of the first AC system S1 or the second AC system S2.

According to an exemplary embodiment, the cooling system is arranged at ground potential, and a coolant of the cooling system is lifted to a position of the converter chain through water cooling pipes.

According to an exemplary embodiment, the high-voltage isolation transformer 5 is positioned at ground potential and comprises a primary insulation bushing 13 and a secondary insulation bushing 14.

According to some embodiments, insulation voltages to ground of the primary winding, the secondary winding, the primary insulation bushing 13, and the secondary insulation bushing 14 of the high-voltage isolation transformer 5 are not less than a voltage to ground of the first AC system S1 or the second AC system S2.

According to an exemplary embodiment, the high-voltage direct-mounted flexible AC closed-loop device further comprises a control system 15 communicating with the converter chain via optical fibers.

Fig. 7 is a diagram of the arrangement of a three-phase high-voltage direct-mounted flexible AC closed-loop device according to an exemplary embodiment.

As shown in Fig. 7, using the layout of the single-phase high-voltage direct-mounted flexible AC closed-loop device from Fig. 4 as an example, the arrangement of the three-phase high-voltage direct-mounted flexible AC closed-loop device is as follows: each phase of the converter chain is connected between corresponding phases of the first AC system and the second AC system, and the converter chain and the multi-winding transformers are arranged by phase and placed on the high-potential platform supported by the insulators above ground, achieving the insulation configuration for the high-voltage direct-mounted flexible AC closed-loop device.

It should be clearly understood that this application describes how to form and use specific examples, but this application is not limited to any details of these examples. On the contrary, based on the teachings of the disclosure, these principles can be applied to many other embodiments.

In addition, it should be noted that the above drawings are only illustrations of the processes included in the method according to the exemplary embodiments of the application, and are not for limiting purposes. It is easy to understand that the processes shown in the above figures do not indicate or limit the time sequence of these processes. In addition, it is also easy to understand that these processes can be performed synchronously or asynchronously in multiple modules, for example.

Exemplary embodiments of the application have been particularly shown and described above. It should be understood that this application is not limited to the detailed structure, arrangement or implementation described here; on the contrary, this application is intended to cover various modifications and equivalent arrangements included within the spirit and scope of the appended claims.

## Claims

1. A high-voltage direct-mounted flexible AC closed-loop device, comprising a three-phase converter chain and three multi-winding transformers, wherein
the three-phase converter chain connects a first AC system and a second AC system, each phase of the converter chain comprises N active submodules connected in series and a series reactor, and N is an integer greater than or equal to 1;
each of the multi-winding transformers comprises a primary winding and N first secondary windings, with the N first secondary windings being connected to the N active submodules in a one-to-one correspondence mode; and
the primary winding of each multi-winding transformer is connected to the first AC system or the second AC system.

2. The high-voltage direct-mounted flexible AC closed-loop device according to claim 1, wherein each phase of the converter chain further comprises a reactive submodule or a plurality of reactive submodules connected in series.

3. The high-voltage direct-mounted flexible AC closed-loop device according to claim 1, wherein the multi-winding transformer further comprises K second secondary windings, K is an integer greater than or equal to 1, and the K second secondary windings are led out to serve as AC ports of the high-voltage direct-mounted flexible AC closed-loop device.

4. The high-voltage direct-mounted flexible AC closed-loop device according to claim 2, wherein
any one of the N active submodules comprises a first bridge circuit, a first DC capacitor, and a first full-bridge circuit, a DC terminal of the first bridge circuit and a DC terminal of the first full-bridge circuit are connected in parallel with the first DC capacitor, and the first bridge circuit comprises a single-phase full-bridge structure or a three-phase half-bridge structure;
any one of the one or more reactive submodules comprises a second full-bridge circuit and a second DC capacitor, and a DC terminal of the second full-bridge circuit is connected in parallel with the second DC capacitor; and
an AC terminal of the first full-bridge circuit is connected in series with an AC terminal of the second full-bridge circuit, and an AC terminal of the first bridge circuit is connected to the corresponding first secondary winding.

5. The high-voltage direct-mounted flexible AC closed-loop device according to claim 4, further comprising:
a bypass switch, configured at the AC terminal of the first full-bridge circuit or the AC terminal of the second full-bridge circuit, wherein the bypass switch closes in an event of a fault in the active submodules or reactive submodules.

6. The high-voltage direct-mounted flexible AC closed-loop device according to claim 1, further comprising:
three high-voltage isolation transformers, wherein primary windings of the high-voltage isolation transformers are connected in parallel and then connected to the first AC system or the second AC system, or independently connected to the first AC system or the second AC system, and secondary windings of the high-voltage isolation transformers are connected to the primary windings of the corresponding multi-winding transformers, respectively.

7. The high-voltage direct-mounted flexible AC closed-loop device according to claim 6, wherein a line voltage of the secondary winding of the high-voltage isolation transformer is less than that of the primary winding thereof, and an insulation voltage to ground of the secondary winding of the high-voltage isolation transformer is not less than that of the primary winding thereof.

8. The high-voltage direct-mounted flexible AC closed-loop device according to claim 6, wherein the high-voltage isolation transformer is positioned at ground potential and further comprises a primary insulation bushing and a secondary insulation bushing, and insulation voltages to ground of the primary winding, the secondary winding, the primary insulation bushing, and the secondary insulation bushing of the high-voltage isolation transformer are not less than a voltage to ground of the first AC system or the second AC system.

9. The high-voltage direct-mounted flexible AC closed-loop device according to claim **1,** further comprising insulators above ground and a high-potential platform,
wherein the insulators above ground are used to support the high-potential platform, and the converter chain and the multi-winding transformers are mounted on the high-potential platform; and
an insulation voltage of the insulator above ground is not less than a voltage to ground of the first AC system or the second AC system.

10. The high-voltage direct-mounted flexible AC closed-loop device according to claim 9, wherein
the high-potential platform is a metal platform;
the converter chain is supported on the metal platform by platform insulators or is arranged within a box structure on the metal platform;
the series reactor is supported on the metal platform by platform insulators or supported on the ground by insulators above ground; and
the multi-winding transformers are placed on the metal platform.

11. The high-voltage direct-mounted flexible AC closed-loop device according to claim 3, wherein where the high-voltage direct-mounted flexible AC closed-loop device is arranged outdoors, the three-phase converter chain is placed inside a container, the N first secondary windings of the multi-winding transformer pass through the container and are correspondingly connected to the N active submodules, and the K second secondary windings of the multi-winding transformer pass through the container and are connected to a cooling system.

12. The high-voltage direct-mounted flexible AC closed-loop device according to claim 9 or 11, further comprising a cooling system, wherein an air cooler of the cooling system is arranged at a top of the converter chain or the container.

13. The high-voltage direct-mounted flexible AC closed-loop device according to claim 6, wherein where the three-phase converter chain and the multi-winding transformers are arranged indoors, and where the high-voltage isolation transformers and the series reactor are placed outdoors, the secondary windings of the high-voltage isolation transformers and the primary windings of the multi-winding transformers are connected via wall bushings; and
an insulation voltage to ground of the wall bushing is not less than a voltage to ground of the first AC system or the second AC system.

14. The high-voltage direct-mounted flexible AC closed-loop device according to claim 13, further comprising:
a cooling system comprising at least one of: a cooling subunit, a water cooling system, and an air conditioning system.

15. The high-voltage direct-mounted flexible AC closed-loop device according to claim 14, wherein the cooling system is arranged at ground potential, and a coolant of the cooling system is lifted to a position of the converter chain through water cooling pipes.

16. The high-voltage direct-mounted flexible AC closed-loop device according to claim 1, further comprising:
a control system communicating with the converter chain via optical fibers.
